# EUROPEAN PATENT APPLICATION

(11) **EP 4 462 962 A1**
(43) Date of publication of application: **13.11.2024**
(21) Application number: 23857666.4
(22) Date of filing: 21.08.2023
(51) Int. Cl.: H05K 3/32, H01M 50/519, H01M 50/536

(54) **PCB COMPRISING LASER BLOCKING UNIT, AND BATTERY CELL ASSEMBLY COMPRISING SAME**

(30) Priority: 22.08.2022 KR 20220105080
(71) Applicant: LG Energy Solution, Ltd., Seoul 07335 (KR)
(72) Inventor: HWANG, Jo Yeon, Daejeon 34122 (KR); LEE, Jin Hyun, Daejeon 34122 (KR); JANG, Jae Young, Daejeon 34122 (KR)
(74) Representative: Plasseraud IP
(86) International application number: PCT/KR2023/012318
(87) International publication number: WO 2024/043634

(57) **Abstract**

The present invention relates to a PCB including a first layer including a weld spot for laser welding and a laser blocking portion included in a second layer under the first layer, the laser blocking portion being located at a same position as the weld spot in a direction in which the first layer and the second layer are stacked, wherein the laser blocking portion includes a material configured to reflect a laser radiated for welding at the weld spot or to prevent the laser from passing therethrough while the weld spot is being welded.

## Description

### [Technical Field]

This application claims the benefit of priority to Korean Patent Application No. 2022-0105080 filed on August 22, 2022, the disclosure of which is incorporated herein by reference in its entirety.

The present invention relates to a PCB including a laser blocking portion. More particularly, the present invention relates to a PCB including a laser blocking portion capable of preventing a circuit on a layer under a weld spot of the PCB from being damaged by a laser radiated to the weld spot and a battery cell assembly including the same.

### [Background Art]

In a lithium secondary battery, the temperature, voltage, etc. of a battery cell are measured and monitored for safety purposes. The battery cell is electrically connected to a PCB manufactured for this purpose, and an electrode lead of the battery cell is often welded to a weld spot of the PCB. In the past, welding was performed using a soldering station or a soldering iron, but laser welding has often been used in recent years.

Laser welding is applicable to a small region, and the properties of a material before and after welding are the same, whereby the mechanical properties of the material after welding are excellent, and efficiency thereof is high, and therefore laser welding is often used in large-scale processes with automation systems.

When an electrode lead is welded to a weld spot of a PCB using a laser, a problem occurs if the laser is not accurately focused on the weld spot of the PCB. Even though the laser is radiated to a correct position, the laser affects other layers in the PCB if the depth of focus (DOF) of the laser is greater than the sum of the thicknesses of the weld spot of the PCB and the electrode lead. This may be especially problematic if the interlayer thickness of the PCB is small.

For example, when the DOF of the laser is formed between the uppermost layer of the PCB and a lower layer thereunder, the laser may affect the lower layer. The uppermost layer and the lower layer may be welded to each other. As a result, a circuit formed on the lower layer may be damaged.

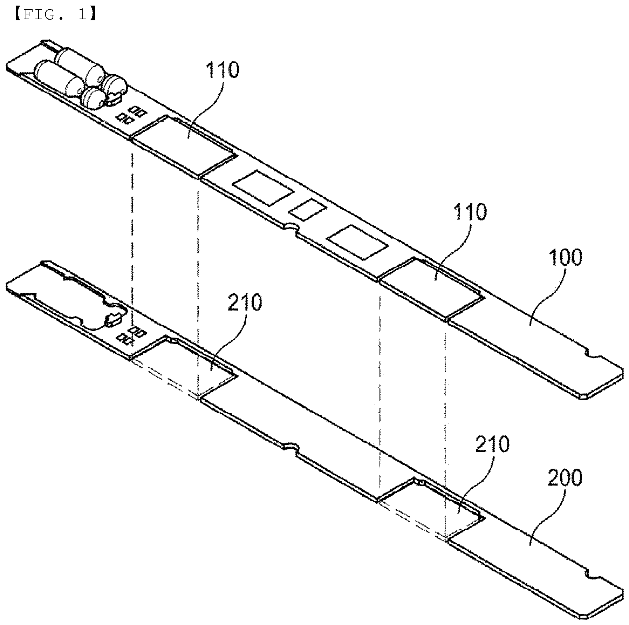

FIG. 1 is an exploded perspective view of a PCB according to a related art. FIG. 1 shows, as an example, a first uppermost layer 100 constituting the PCB and a second layer 200 located thereunder. Although not shown in FIG. 1, an adhesive layer may be added between the first layer 100 and the second layer 200.

The first layer 100 includes two weld spots 110, to each of which a corresponding one of a positive electrode lead and a negative electrode lead of a pouch-shaped battery cell is coupled.

The second layer 200 has a circuit pattern printed throughout, but no circuit pattern may be printed at positions corresponding to the two weld spots 110 in an upward-downward direction. In FIG. 1, an empty space 210 is formed at a position corresponding to each of the two weld spots 110 in the upward-downward direction. The second layer 200 has a circuit pattern formed in the remaining part thereof excluding the empty spaces 210.

If no circuit pattern is formed under the uppermost layer having the weld spot, if a laser is not focused on the weld spot even though a simple empty space is formed, or if the DOF of the laser is formed up to the adhesive layer such as prepreg between the first layer and the second layer thereunder, there is a problem that the uppermost layer and the layer thereunder may be welded to each other.

This problem may occur in a layer between the first layer and the second layer as well as the first layer, which is the uppermost layer, and the second layer, which is under the first layer.

Such welding defect problem is directly related to the safety of a battery cell, a battery module, or a battery pack, and a thin PCB is used in a battery, and therefore there is a need for a means configured to fundamentally solve this problem. In laser welding of the PCB, there is a need for technology capable of preventing damage to an internal circuit, even when a laser is out of focus or the DOF of the laser is large.

In Patent Document 1, a deep cavity is formed in a PCB in order to insert various parts into the PCB. When a laser is radiated to form the cavity, a metal pattern that serves as a laser stopper is formed; however, this patent document does not recognize technology capable of preventing the laser from unnecessarily affecting other layers when an electrode lead is welded to the PCB.

Patent Documents 2 to 5 do not specifically disclose any means configured to block a laser such that the laser cannot affect other layers.

As such, there is no clear solution capable of preventing damage to an internal circuit even when a laser is out of focus or even when the DOF of laser is large in laser welding of a PCB.

### (Prior Art Documents)

(Patent Document 01) Korean Patent Application Publication No. 2017-0067472
(Patent Document 02) Korean Patent Application Publication No. 2018-0036404
(Patent Document 03) Korean Patent Application Publication No. 2016-0055539
(Patent Document 04) Korean Patent Application Publication No. 2018-0013669
(Patent Document 05) Japanese Patent Application Publication No. 1996-304668

### [Disclosure]

### [Technical Problem]

The present invention has been made in view of the above problems, and it is an object of the present invention to provide a PCB capable of preventing damage to an internal circuit of the PCB even when a laser is out of focus or even when the DOF of laser is large and a laser welding method using the same.

### [Technical Solution]

A PCB according to the present invention to accomplish the above object may include a first layer including a weld spot for laser welding, and a laser blocking portion included in a second layer under the first layer, the laser blocking portion being located at a same position as the weld spot in a direction in which the first layer and the second layer are stacked, wherein the laser blocking portion includes a material configured to reflect a laser radiated for welding at the weld spot or to prevent the laser from passing therethrough while the weld spot is being welded.

The laser blocking portion may be configured to have a size encompassing an entire region of the weld spot based on the direction in which the first layer and the second layer are stacked.

The laser blocking portion may be made of a non-conductive material or a conductive material, and wherein the laser blocking portion may not be electrically connected to any circuit on the PCB.

The laser blocking portion may include at least one of a metal, a ceramic, and a polymer.

The laser blocking portion may include at least one of silver, copper, aluminum, iron, and nickel.

The laser blocking portion may be made of a same material as metal foil used for a circuit pattern on the PCB.

The laser blocking portion may be located at the uppermost end of the second layer.

An adhesive layer may be added between the first layer and the second layer.

The present invention provides a battery cell assembly including the PCB.

In the battery cell assembly, an electrode lead of a battery cell may be welded to the weld spot of the first layer.

The present invention provides a welding method using the PCB, specifically a laser welding method.

In addition, the present invention may provide various combinations of the above solving means.

### [Advantageous Effects]

As is apparent from the above description, a PCB according to the present invention is capable of preventing a laser from penetrating the interior of the PCB, whereby it is possible to prevent unwanted welding in the PCB.

In addition, it is possible to prevent damage to a circuit pattern formed on the PCB by the laser penetrating the interior of the PCB.

In addition, the laser blocking portion is not electrically connected to a circuit pattern constituting the PCB, and therefore other circuit patterns formed on the PCB are not affected even though the DOF of a laser includes a second layer.

### [Description of Drawings]

FIG. 1 is an exploded perspective view of a PCB according to a related art.
FIG. 2 is an exploded perspective view of a PCB according to the present invention.
FIG. 3 is a plan view of a part of a battery cell assembly configured such that an electrode lead of a pouch-shaped battery cell is coupled to the PCB of FIG. 2.
FIG. 4 is vertical sectional views when an electrode lead is coupled to the conventional PCB and the case in which an electrode lead is coupled to the PCB according to the present invention.
FIG. 5 is photographs showing the results of welding according to a comparative example.
FIG. 6 is photographs showing the results of welding according to an example.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

In addition, a description to embody elements through limitation or addition may be applied to all inventions, unless particularly restricted, and does not limit a specific invention.

Also, in the description of the invention and the claims of the present application, singular forms are intended to include plural forms unless mentioned otherwise.

Also, in the description of the invention and the claims of the present application, "or" includes "and" unless mentioned otherwise. Therefore, "including A or B" means three cases, namely, the case including A, the case including B, and the case including A and B.

Hereinafter, an embodiment of the present invention will be described in detail with reference to the drawings.

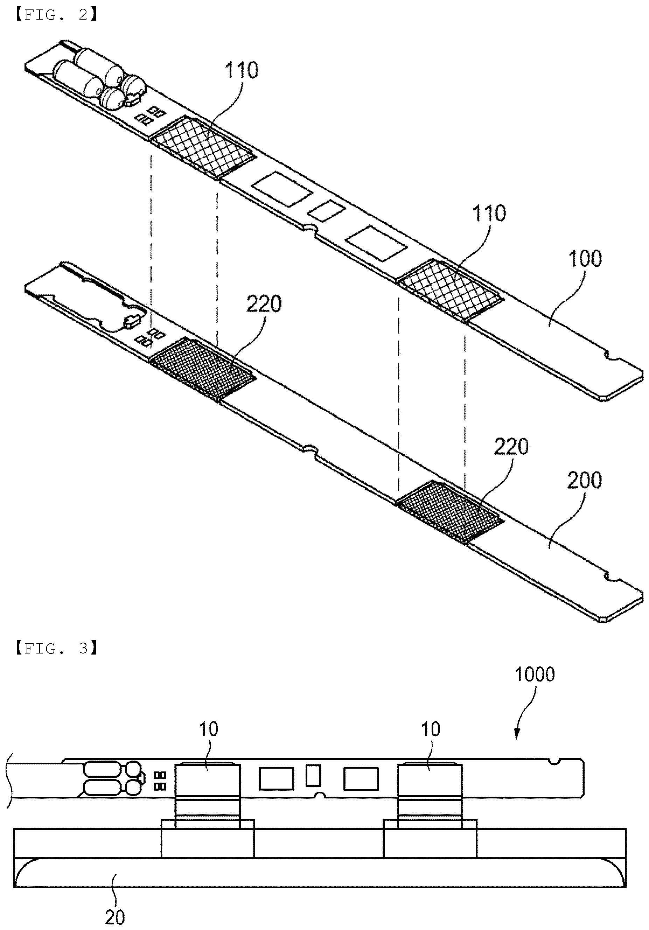

FIG. 2 is an exploded perspective view of a PCB according to the present invention. Here, PCB stands for printed circuit board. In general, FR-4, which is an epoxy-set glass fiber material, is used, and parts may be electrically connected to each other via copper plates attached to opposite surfaces of FR-4.

Referring to FIG. 2, the PCB according to the present invention includes a first layer 100 located at the uppermost layer, the first layer including a weld spot 110 for laser welding, and a second layer 200, which is located under the first layer 200. The second layer 200 includes a laser blocking portion 220 located at the same position as the weld spot 110 in a direction in which the first layer 100 and the second layer 200 are stacked. The laser blocking portion 220 is configured to completely overlap the weld spot 110 under the weld spot 110 or to have a sufficient size to encompass the region of the weld spot 110 in the direction in which the first layer 100 and the second layer 200 are stacked.

The first layer 100 may include the weld spot 110, via which an external device, such as an electrode lead of a pouch-shaped battery cell, is coupled to the PCB, and a circuit pattern may be formed on the remaining part excluding the weld spot. The circuit pattern is a conductive pattern formed on a substrate using a conductive material such as copper, and may include a signal circuit pattern for signal transmission, a power layer for power supply, and a ground layer for power stop.

The second layer 200 may be configured to have a structure having two or more layers, such as a circuit pattern layer and a base layer, and the laser blocking portion 220 may be disposed at the uppermost end of the second layer 200 in order to prevent a laser from being incident on the second layer 200. Even though the laser is incident on the second layer 200 to the depth thereof, the laser is reflected or blocked by the laser blocking portion 220 disposed at the uppermost end of the second layer 200.

The laser blocking portion 220 may include a material configured to reflect a laser that is radiated for welding at the weld spot 110 or to prevent the laser from passing therethrough while the weld spot 110 is being welded.

The laser blocking portion 220 may be made of a non-conductive material or a conductive material, and may not be electrically connected to any circuit on the PCB.

As a result, the DOF of the laser includes the second layer, whereby the circuit pattern formed on the second layer is not affected even though the first layer and the second layer are coupled to each other.

Specifically, the laser blocking portion 220 may include at least one of a metal, a ceramic, and a polymer. For example, the laser blocking portion may include at least one of silver, copper, aluminum, iron, and nickel.

In a specific example, the laser blocking portion 220 may be made of the same material as metal foil used for the circuit pattern on the PCB.

When a green laser is used for laser welding, copper may be used as the laser blocking portion in consideration of the fact that copper reflects the green laser.

FIG. 3 is a plan view of a part of a battery cell assembly configured such that an electrode lead of a pouch-shaped battery cell is coupled to the PCB of FIG. 2.

Referring to FIG. 3, the pouch-shaped battery cell 20 is manufactured by receiving an electrode assembly in a pouch-shaped battery case made of a laminated sheet including an outer covering layer, a metal layer, and an inner adhesive layer and sealing the pouch-shaped battery case.

The electrode assembly may be a stacked type electrode assembly configured such that a positive electrode and a negative electrode are stacked in the state in which a separator is interposed therebetween. The positive electrode and the negative electrode respectively include a positive electrode tab and a negative electrode tab, each of which protrudes to one side and serves as a current movement path. The positive electrode tab is connected to a positive electrode lead, and the negative electrode tab is connected to a negative electrode lead.

Electrode leads 10, including the positive electrode lead and the negative electrode lead, protrude outwardly from an outer periphery of one side of the pouch-shaped battery case. The electrode leads 10 are coupled to the weld spot on the PCB by laser welding, whereby the battery cell assembly 1000 including the PCB is assembled.

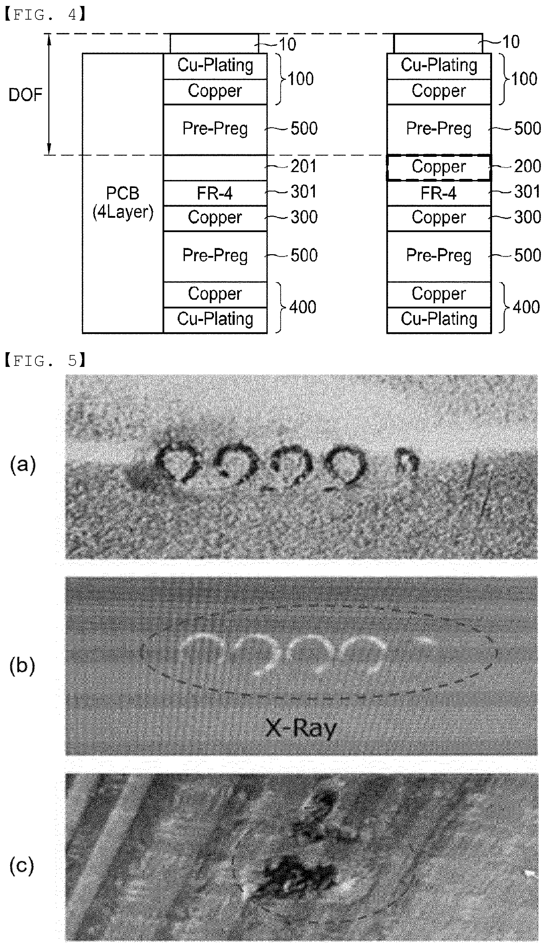

FIG. 4 is vertical sectional views when an electrode lead is coupled to the conventional PCB and the case in which an electrode lead is coupled to the PCB according to the present invention.

(a) of FIG. 4 is a vertical sectional view when the electrode lead is coupled to the conventional PCB, and (b) of FIG. 4 is a vertical sectional view when the electrode lead is coupled to the PCB according to the present invention.

Referring to FIG. 4, an electrode lead 10 is disposed on an upper surface of a copper plate as a weld spot on an upper surface of a first layer 100 of the PCB, and the electrode lead 10 and the PCB are coupled to each other by laser welding in which a laser is radiated from above the electrode lead 10.

The first layer 100 of the PCB not only includes the weld spot but also has a circuit pattern printed on a base layer, the circuit pattern being made of an electrically conductive material. The base layer may be made of a flexible and insulative film, and may include, for example, a polyimide material. Specifically, polyimide may be combined with transparent polyester or polypropylene to maximize light transparency.

The circuit pattern, which is configured to transmit a predetermined electrical signal, may be formed so as to have a thickness of about 5 um to about 20 µm, and may be made of a metal material such as copper foil (Cu). The surface of the copper foil may be plated with a metal such as tin, gold, or nickel.

The PCB shown in (a) of FIG. 4 includes a prepreg layer 500 located under the first layer 100, the prepreg layer being provided for insulation and adhesion, a third layer 300 having copper foil formed only on a lower surface of FR-4 301, and a fourth layer 400 located at the lowermost end of the PCB, the fourth layer including a copper plate and copper foil.

FR-4 is made of a material obtained by combining an epoxy resin and glass fiber with each other, and means a type of "copper foil laminate" having copper foil applied to one surface or opposite surfaces.

Between the third layer 300 and the fourth layer 400 is further provided a prepreg layer 500 configured to couple the third layer and the fourth layer to each other.

An empty space 201 is located between the prepreg layer 500 under the first layer 100 and the FR-4, and a DOF is formed from the electrode lead 100 to the prepreg layer 500 under the first layer 100.

If the DOF is out of focus, a laser may penetrate even the third layer 300, or alternatively, the first layer and the third layer 300 including the FR-4 301 may be welded through the prepreg layer 500.

The PCB shown in (b) of FIG. 4 is different from the PCB shown in (a) of FIG. 4 in that a second layer 200 is added.

Specifically, an electrode lead 10 is disposed on an upper surface of a copper plate as a weld spot on an upper surface of a first layer 100, and the electrode lead 10 and the PCB are coupled to each other by laser welding in which a laser is radiated from above the electrode lead 10.

In the PCB shown in (b) of FIG. 4, a third layer 300 has copper foil applied to opposite surfaces of FR-4 301, and a second layer 200 formed on an upper surface of the FR-4 functions as a laser blocking layer configured to reflect or block a laser when the DOF extends to the depth of the second layer 200. The second layer 200 may be configured so as not to be electrically connected to circuit patterns formed on the first layer 100, the third layer 300, and a fourth layer 400 such that the circuit patterns formed on the first layer 100, the third layer 300, and the fourth layer 400 are not affected by laser welding.

However, the circuit patterns formed on the first layer 100, the third layer 300, and the fourth layer 400 may be electrically connected to each other.

In the PCB shown in (b) of FIG. 4, a prepreg layer 500 is interposed between the first layer 100 and the second layer 200 as an adhesive layer configured to adhere the first layer and the second layer to each other. The prepreg layer 500 is adhesive and insulative. Even though the third layer 300 and the fourth layer 400 are adhered to each other via a prepreg layer 500 therebetween, therefore, the third layer 300 and the fourth layer 400 are not connected to each other via the prepreg layer 500 unless a configuration for connecting the third layer 300 and the fourth layer 400 is included.

As such, the PCB according to the present invention and the battery cell assembly including the same include a laser blocking portion in the second layer 200 under the first layer of the PCB, whereby a laser may be reflected or blocked by the laser blocking portion even though the DOF of the laser is deepened or defocused, and therefore it is possible to prevent poor laser welding.

Hereinafter, the present invention will be described with reference to an example. The example is provided only for easier understanding of the present invention and should not be construed as limiting the category of the present invention.

### <Comparative Example>

A nickel plate was disposed on a PCB including a second layer having no laser blocking portion under a first layer of the PCB, and laser welding was performed on the nickel plate toward the PCB.

At this time, the DOF of the laser was set to reach the first layer of the PCB and the second layer having no laser blocking portion, and welding was performed.

FIG. 5 is photographs showing the results of welding according to the comparative example.

(a) of FIG. 5 is a photograph of a laser weld of the nickel plate, (b) of FIG. 5 is an X-ray photograph of the first layer of the PCB with the nickel plate removed, and (c) of FIG. 5 is a photograph of the second layer of the PCB.

(a) of FIG. 5 shows that circular laser welds have been continuously formed on an upper surface of the nickel plate in a transverse direction. Referring to the X-ray photograph of the first layer of the PCB shown in (b) of FIG. 5, it can be seen that the first layer of the PCB has holes in the same shape as the laser welds shown in (a) of FIG. 5, and it can be seen from (c) of FIG. 5 that a circuit pattern formed on the second layer of the PCB has marks burned by a laser.

Consequently, it can be seen that, if a configuration that blocks a laser beam for laser welding is not included in the PCB, the laser beam penetrates not only the first layer but also the second layer of the PCB, whereby the circuit pattern can be damaged.

### <Example>

A nickel plate was disposed on a PCB including a second layer having a laser blocking portion under a first layer of the PCB, and laser welding was performed on the nickel plate toward the PCB.

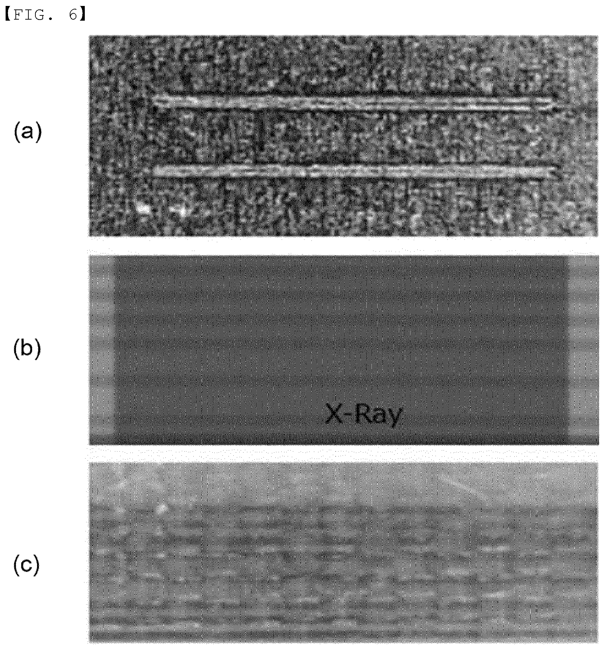

FIG. 6 is photographs showing the results of welding according to the example.

(a) of FIG. 6 is a photograph of a laser weld of the nickel plate, (b) of FIG. 6 is an X-ray photograph of the first layer of the PCB with the nickel plate removed, and (c) of FIG. 6 is a photograph of the second layer of the PCB.

(a) of FIG. 6 shows that two rows of continuous linear laser welds are formed on an upper surface of the nickel plate in a transverse direction. Referring to the X-ray photograph of the first layer of the PCB shown in (b) of FIG. 6, it can be seen that the first layer of the PCB has no hole marks corresponding to the laser welds, unlike (b) of FIG. 5. Also, it can be seen from (c) of FIG. 6 that a circuit pattern formed on the second layer of the PCB is not damaged, unlike (c) of FIG. 5.

When laser welding is performed using a PCB including a laser blocking portion, as in the present invention, therefore, a laser beam may be blocked under a first surface coupled to a nickel plate, whereby it is possible to prevent damage to an internal circuit of the PCB while securing weldability between the nickel plate and the PCB.

Those skilled in the art to which the present invention pertains will appreciate that various applications and modifications are possible within the category of the present invention based on the above description.

### (Description of Reference Numerals)

10: Electrode lead
20: Pouch-shaped battery cell
100: First layer
110: Weld spot
200: Second layer
201, 210: Empty spaces
220: Laser blocking portion
300: Third layer
301: FR-4
400: Fourth layer
500: Prepreg layer
1000: Battery cell assembly

## Claims

1. A PCB comprising:
a first layer comprising a weld spot for laser welding; and
a laser blocking portion included in a second layer under the first layer, the laser blocking portion being located at a same position as the weld spot in a direction in which the first layer and the second layer are stacked,
wherein the laser blocking portion comprises a material configured to reflect a laser radiated for welding at the weld spot or prevent the laser from passing therethrough while the weld spot is being welded.

2. The PCB according to claim 1, wherein the laser blocking portion is configured to have a size encompassing an entire region of the weld spot based on the direction in which the first layer and the second layer are stacked.

3. The PCB according to claim 1, wherein the laser blocking portion is made of a non-conductive material or a conductive material, and
wherein the laser blocking portion is not electrically connected to any circuit on the PCB.

4. The PCB according to claim 3, wherein the laser blocking portion comprises at least one of a metal, a ceramic, and a polymer.

5. The PCB according to claim 4, wherein the laser blocking portion comprises at least one of silver, copper, aluminum, iron, and nickel.

6. The PCB according to claim 1, wherein the laser blocking portion is made of a same material as metal foil used for a circuit pattern on the PCB.

7. The PCB according to claim 1, wherein the laser blocking portion is located at an uppermost end of the second layer.

8. The PCB according to claim 1, further comprising an adhesive layer added between the first layer and the second layer.

9. A battery cell assembly comprising the PCB according to any one of claims 1 to 8.

10. The battery cell assembly according to claim 9, wherein an electrode lead of a battery cell is welded to the weld spot of the first layer.

11. A welding method using the PCB according to any one of claims 1 to 8.
